# EUROPEAN PATENT APPLICATION

(11) **EP 1 890 328 A1**
(43) Date of publication of application: **20.02.2008**
(21) Application number: 06713662.2
(22) Date of filing: 14.02.2006
(51) Int. Cl.: H01L 21/822, H01L 27/04

(54) **SEMICONDUCTOR INTEGRATED CIRCUIT**

(30) Priority: 06.06.2005 JP 2005165407
(71) Applicant: MATSUSHITA ELECTRIC INDUSTRIAL CO., LTD., Osaka 571-8501 (JP)
(72) Inventor: KAKEMIZU, Takashi, c/o Matsushita Elec. Ind. Co.,Ltd., Chuo-ku,Osaka-shi,Osaka 540-6319 (JP); FUKOMOTO, Yoshihiko, c/o Matsushita Elec. Ind. Co.,Ltd., Chuo-ku,Osaka-shi,Osaka 540-6319 (JP)
(74) Representative: Grünecker, Kinkeldey, Stockmair & Schwanhäusser Anwaltssozietät
(86) International application number: PCT/JP2006/302521
(87) International publication number: WO 2006/132007

(57) **Abstract**

Between an analog circuit area **120** which includes circuits whose characteristics are degraded according to the level of noise contained in an input signal and a digital circuit area **130** which includes circuits that produce noise at such a level that the characteristics of the circuits in the analog circuit area **120** are caused to degrade, a digital circuit area **140** which only includes circuits that produce noise at such a level that the characteristics of the circuits in the analog circuit area **120** are not caused to degrade (or are caused to degrade within their acceptable limits) is located so as to prevent contact between the analog circuit area **120** and the digital circuit area **130.**

## Description

### TECHNICAL FIELD

The present invention relates to a semiconductor integrated circuit in which circuits whose characteristics are degraded due to noise and circuits that produce the noise are both included.

### BACKGROUND ART

As today's semiconductor integrated circuits are called system-on-chips or system LSIs, many functions are integrated on a single semiconductor integrated circuit. In such a semiconductor integrated circuit, noise-sensitive analog circuits and digital circuits which produce noise that causes degradation of the characteristics of the analog circuits may be both included. In that case, it is necessary to prevent the noise produced from the digital circuits from propagating to the analog circuits, so as to avoid degradation of the characteristics of the analog circuits.

As a semiconductor integrated circuit having a structure for preventing propagation of noise produced from digital circuits to analog circuits, there has been a known semiconductor integrated circuit in which, for example, a guard band is provided between analog circuits and digital circuits to reduce noise propagation (see Patent Documents 1 and 2, for example).

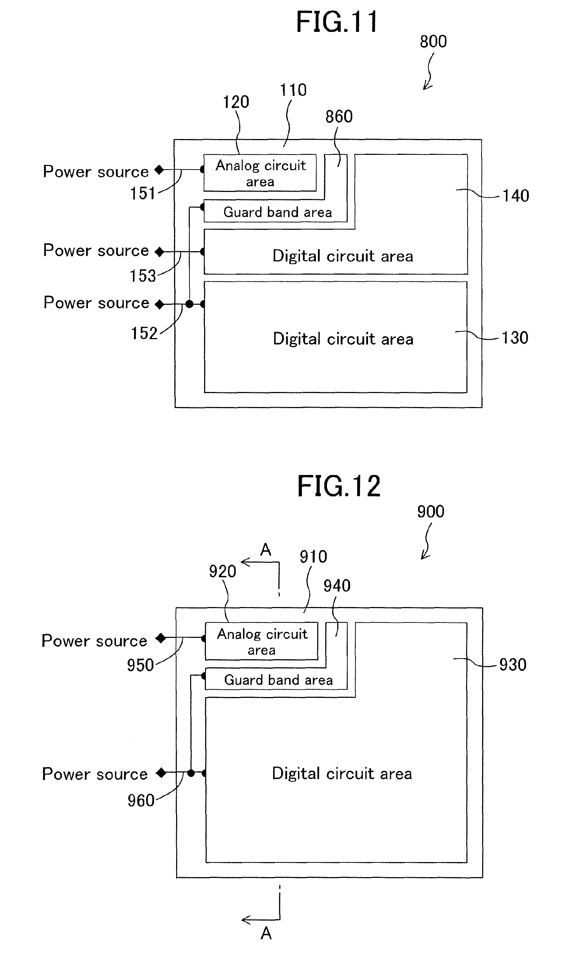

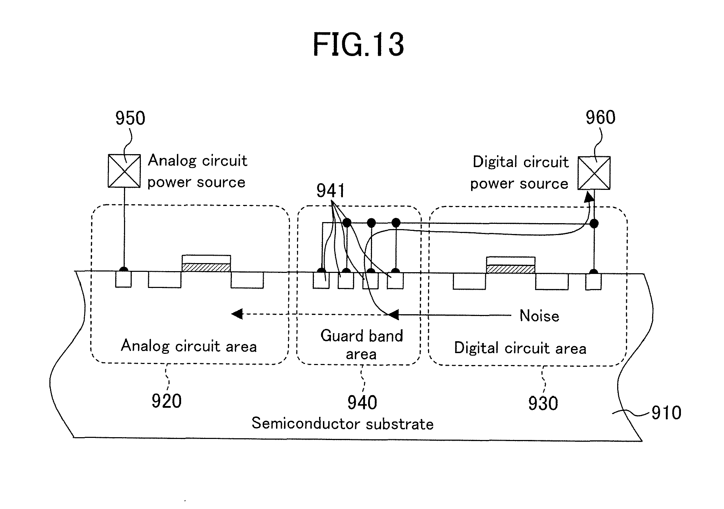

FIG. **12** is a plan view illustrating the structure of a semiconductor integrated circuit **900** in which the above-described guard band is provided. FIG. **13** is a cross-sectional view (taken along the section line A-A of FIG. **12****)** of the semiconductor integrated circuit **900.**

As shown in FIG. **12****,** the semiconductor integrated circuit **900** includes a semiconductor substrate **910,** an analog circuit area **920,** a digital circuit area **930,** a guard band area **940,** an analog circuit power source **950,** and a digital circuit power source **960.**

On the semiconductor substrate **910,** analog circuits and digital circuits are both mounted.

The analog circuit area **920** is an area where the analog circuits are formed. The circuits in this area are sensitive to noise and the characteristics thereof are thus degraded by noise propagated through the power source and the like.

The digital circuit area **930** is an area including the digital circuits that produce noise at such a level that the characteristics of the circuits in the analog circuit area **920** are degraded.

The guard band area **940** includes substrate contacts **941,** which are connected to the digital circuit power source **960.**

The analog circuit power source **950** supplies power supply voltage to the circuits in the analog circuit area **920.**

The digital circuit power source **960** supplies power supply voltage to the circuits in the digital circuit area **930.**

In the semiconductor integrated circuit **900,** the analog circuit area **920** and the digital circuit area **930** are on the semiconductor substrate **910,** and the guard band area **940** is provided between the analog circuit area **920** and the digital circuit area **930.**

In the semiconductor integrated circuit **900** thus structured, noise produced in the digital circuit area **930** passes through the guard band area **940** before propagating to the analog circuit area **920.** At this time, as shown in FIG. **13****,** the noise passes through the substrate contacts **941** and the digital circuit power source **960** to go outside the semiconductor substrate **910.** Specifically, the noise is absorbed in the guard band area **940** and is allowed to go outside the semiconductor substrate **910.** Accordingly, the noise occurring in the digital circuit area **930** does not propagate to the analog circuit area **920,** whereby it is possible to prevent degradation of the characteristics of the circuits in the analog circuit area **920.**
Patent Document 1: Patent Publication No. 3075892
Patent Document 2: Japanese Laid-Open Publication No. 2002-246553

### DISCLOSURE OF THE INVENTION

### PROBLEM THAT THE INVENTION INTENDS TO SOLVE

However, the above-described conventional semiconductor integrated circuit has a problem in that the guard band area is required as a physical area in the semiconductor integrated circuit, which results in increase in the area of the semiconductor integrated circuit. Furthermore, as the size of the guard band area is increased, the guard band area absorbs noise more effectively. Therefore, achieving more effective noise absorption requires more significant increase in the area of the semiconductor integrated circuit.

In view of the above problem, the present invention was made, and it is therefore an object of the present invention to provide a semiconductor integrated circuit in which although circuits (noise-sensitive circuits) whose characteristics are degraded due to noise and circuits that produce the noise are both included, the degradation of the characteristics of the noise-sensitive circuits is prevented without increasing the area of the semiconductor integrated circuit (the semiconductor substrate).

### MEAMS FOR SOLVING THE PROBLEM

In order to solve the above problem, the first invention is a semiconductor integrated circuit including: a protected circuit area including circuits whose characteristics are degraded according to the level of noise; a high noise circuit area including circuits that produce noise at such a level that an amount of degradation caused in the circuits in the protected circuit area due to the noise exceeds an acceptable amount of degradation for the circuits in the protected circuit area; a low noise circuit area including circuits that produce noise at such a level that an amount of degradation caused in the circuits in the protected circuit area due to the noise is within the acceptable amount of degradation for the circuits in the protected circuit area; and three or more separate power sources whose paths for supplying power supply voltage are separate from each other, wherein the low noise circuit area is located between the protected circuit area and the high noise circuit area so as to prevent contact between the protected circuit area and the high noise circuit area; and the circuits in the protected circuit area, the circuits in the high noise circuit area, and the circuits in the low noise circuit area are supplied with power supply voltage by different power sources of the three or more separate power sources.

Then, noise produced in the high noise circuit area passes through the low noise circuit area to go outside the semiconductor substrate without propagating to the protected circuit area. The noise produced in the high noise circuit area thus does not propagate to the noise-sensitive protected circuit area. Accordingly, it is possible to prevent degradation of the characteristics of the circuits in the protected circuit area.

According to the second invention, in the semiconductor integrated circuit of the first invention, the circuits in the high noise circuit area and the circuits in the low noise circuit area produce noise at levels corresponding to the levels of the frequencies of signals handled by these circuits, and the maximum frequency of the signals handled in the low noise circuit area is lower than the frequencies of the signals handled in the high noise circuit area.

Then, the high noise circuit area and the low noise circuit area are formed based on the frequencies of the signals handled by the circuits therein.

According to the third invention, in the semiconductor integrated circuit of the first invention, the circuits in the protected circuit area are analog circuits, and the circuits in the high noise circuit area are digital circuits.

According to the fourth invention, in the semiconductor integrated circuit of the second invention, the circuits in the protected circuit area are analog circuits, and the circuits in the high noise circuit area are digital circuits.

Then, where analog circuits and digital circuits are both mounted on a single semiconductor substrate, the analog circuits whose characteristics easily degrade due to noise are protected from noise from the noise-source digital circuits.

### EFFECTS OF THE INVENTION

According to the present invention, it is possible to prevent the characteristics of circuits from degrading due to noise, without increasing the area of the semiconductor integrated circuit.

### BRIEF DESCRIPTION OF DRAWINGS

FIG. **1** is a plan view illustrating the structure of a semiconductor integrated circuit according to a first embodiment of the present invention.
FIG. **2** is a cross-sectional view of the semiconductor integrated circuit according to the first embodiment of the present invention.
FIG. **3** is a plan view illustrating the structure of a semiconductor integrated circuit according to a second embodiment of the present invention.
FIG. **4** is a plan view illustrating a modified example of the semiconductor integrated circuit according to the second embodiment of the present invention.
FIG. **5** is a plan view illustrating the structure of a semiconductor integrated circuit according to a third embodiment of the present invention.
FIG. **6** is a view illustrating connection relation between a semiconductor substrate and lead frames.
FIG. **7** is a plan view illustrating the structure of a semiconductor integrated circuit according to a fourth embodiment of the present invention.
FIG. **8** is a plan view illustrating a modified example of the semiconductor integrated circuit according to the fourth embodiment of the present invention.
FIG. **9** is a plan view illustrating another modified example of the semiconductor integrated circuit according to the fourth embodiment of the present invention.
FIG. **10** indicates spectral distributions of noise produced in digital circuit areas and a spectral distribution of signals handled in an analog circuit area.
FIG. **11** is a plan view illustrating an example in which a guard band area is added to the semiconductor integrated circuit according to the first embodiment of the present invention.
FIG. **12** is a plan view illustrating the structure of a conventional semiconductor integrated circuit.
FIG. **13** is a cross-sectional view of the conventional semiconductor integrated circuit.

### EXPLANATION OF THE REFERENCE CHARACTERS

- 100: Semiconductor integrated circuit
- 110: Semiconductor substrate
- 120: Analog circuit area
- 130: Digital circuit area
- 140: Digital circuit area
- 151 to 153: Power sources
- 160: Lead frame
- 170: Bonding wire
- 180: Bonding pad
- 200: Semiconductor integrated circuit
- 220: Analog circuit area
- 230: Analog circuit area
- 240: Analog circuit area
- 300: Semiconductor integrated circuit
- 320: Digital circuit area
- 330: Digital circuit area
- 340: Digital circuit area
- 400: Semiconductor integrated circuit
- 451 to 455: Power sources
- 500: Semiconductor integrated circuit
- 520: Analog circuit area
- 531 to 532: Digital circuit areas
- 541 to 542: Digital circuit areas
- 591 to 592: Wires
- 600: Semiconductor integrated circuit
- 621 to 623: Analog circuit areas
- 630: Digital circuit area
- 641 to 642: Digital circuit areas
- 690: Wire
- 700: Semiconductor integrated circuit
- 721 to 722: Analog circuit areas
- 730: Digital circuit area
- 741 to 742: Digital circuit areas
- 800: Semiconductor integrated circuit
- 860: Guard band area
- 900: Semiconductor integrated circuit
- 910: Semiconductor substrate
- 920: Analog circuit area
- 930: Digital circuit area
- 940: Guard band area
- 941: Substrate contact
- 950: Analog circuit power source
- 960: Digital circuit power source

### BEST MODE FOR CARRYING OUT THE INVENTION

Hereinafter, embodiments of the present invention will be described with reference to the accompanying drawings.

### (First embodiment)

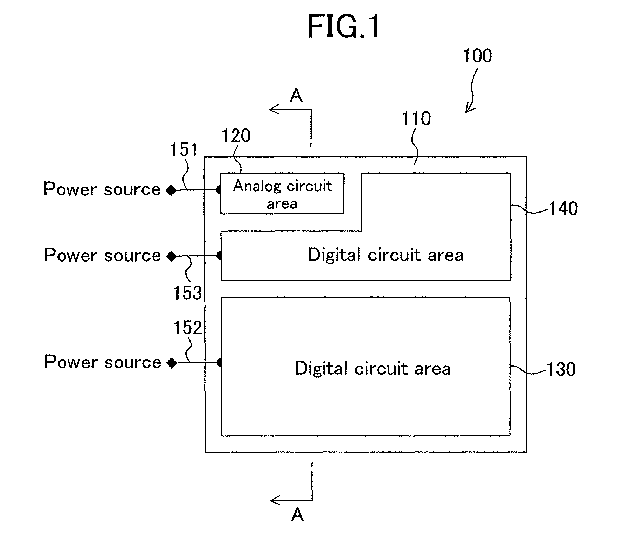

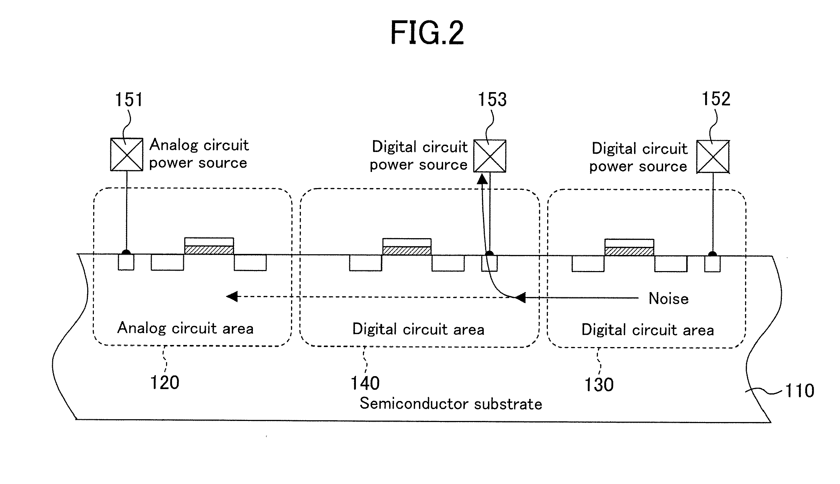

FIG. **1** is a plan view illustrating the structure of a semiconductor integrated circuit **100** according to a first embodiment of the present invention. FIG. **2** is a cross-sectional view (taken along the like A-A of FIG. **1****)** of the semiconductor integrated circuit **100.** As shown in FIG. **1****,** the semiconductor integrated circuit **100** includes a semiconductor substrate **110,** an analog circuit area **120,** a digital circuit area **130,** a digital circuit area **140,** and power sources **151** to **153.**

On the semiconductor substrate **110,** analog semiconductor integrated circuits (analog circuits) and digital semiconductor integrated circuits (digital circuits) are both mounted.

The analog circuit area **120** is an area where the analog circuits are formed. Specific examples of the analog circuits formed in the analog circuit area **120** include a tuner, an AD converter, a DA converter, a PLL (a phase locked loop), a VCO (a voltage controlled oscillator), a filter, and an operational amplifier. These circuits are generally sensitive to noise, and the characteristics thereof are thus degraded according to the level of noise contained in a handled signal and the level of noise propagated thereto through the semiconductor substrate. Therefore, the analog circuit area **120** is an area (a protected circuit area) which should be protected from propagation of noise produced in the other circuit areas.

The digital circuit area **130** is an area (a high noise circuit area) including circuits that produce noise at such a level that the characteristics of the circuits in the protected circuit area are caused to degrade beyond their acceptable limits. In this embodiment, the digital circuit area **130** is an area including digital circuits that produce noise at a level corresponding to the operating frequency thereof. The operating frequency of the circuits in the digital circuit area **130** is 60 MHz.

The digital circuit area **140** is an area (a low noise circuit area) only including circuits that produce noise at such a level that the characteristics of the circuits in the protected circuit area are not caused to degrade (or are caused to degrade within the acceptable limits thereof). The digital circuit area **140** is also an area including digital circuits that produce noise at a level corresponding to the operating frequency thereof. The operating frequency of the circuits in the digital circuit area **140** is 10 MHz. That is, the operating frequency of the circuits in the digital circuit area **130** is higher than that of the circuits in the digital circuit area **140,** and the level of noise produced in the digital circuit area **130** is thus higher than that in the digital circuit area **140.**

As shown in FIG. **1****,** the analog circuit area 120, the digital circuit area **130,** and the digital circuit area **140** are arranged in such a manner that the digital circuit area **140** is physically located between the analog circuit area **120** and the digital circuit area **130** so as to prevent contact between the analog circuit area **120** and the digital circuit area **130.**

The power source **151** supplies power to the analog circuit area **120,** the power source **152** supplies power to the digital circuit area **130,** and the power source **153** supplies power to the digital circuit area **140.** The power sources **151** to **153** are separate power sources that are not connected with each other, and the power supply paths thereof are thus separate from each other.

Once the semiconductor integrated circuit **100** is operated, noise is produced in the digital circuit areas **140** and **130.** The noise produced in the digital circuit area **130** tends to propagate through the semiconductor substrate **110** toward the noise-sensitive analog circuit area **120.**

However, the noise produced in the digital circuit area **130** passes through the digital circuit area **140** before propagation to the analog circuit area **120.** At this time, as shown in FIG. **2****,** the noise produced in the digital circuit area **130** passes through the power source **153** for supplying the digital circuit area **140** with power supply voltage and goes outside the semiconductor substrate **110** without propagating to the analog circuit area **120.** That is, the noise produced in the digital circuit area **130** does not propagate to the noise-sensitive analog circuit area **120.**

Accordingly, in this embodiment, the noise occurring in the high noise circuit area does not propagate to the protected circuit area, whereby it is possible to prevent degradation of the characteristics of the circuits in the protected circuit area.

In addition, no guard band area is necessary, which allows the semiconductor substrate to be reduced in area. Furthermore, the low noise circuit area (the digital circuit area **140)** is typically larger in area than a guard band area, and thus provides more effective noise absorption.

It should be noted that the operating frequencies in the digital circuit areas **140** and **130** are just examples, and are thus not limited to the values mentioned above.

### (Second embodiment)

The type of circuits (i.e., analog circuits or digital circuits) included in each area such as the protected circuit area is not limited to the example described in the first embodiment.

A semiconductor integrated circuit according to a second embodiment is an example in which the type of circuits included in each area such as the protected circuit area is different from that in the first embodiment.

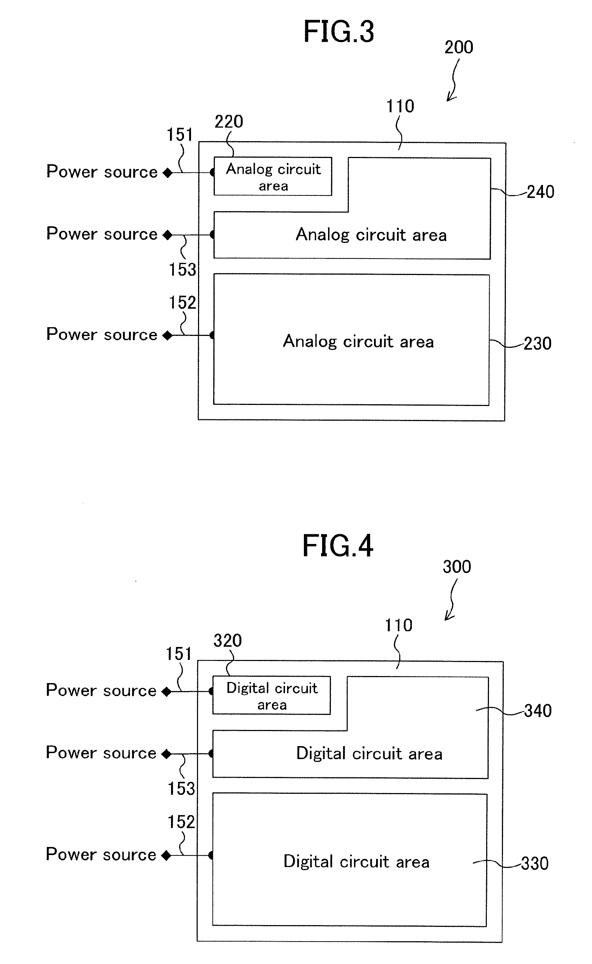

For example, as shown in FIG. **3****,** a semiconductor integrated circuit **200** includes a semiconductor substrate **110,** an analog circuit area **220,** an analog circuit area **230,** and an analog circuit area **240,** and the all circuit areas are thus areas including analog circuits. In the following embodiments and in the modified examples thereof, members functioning in the same manner as those described in the first embodiment and the like are identified by the same reference numerals and the descriptions thereof will be omitted herein.

The analog circuit area **220** (a protected circuit area) is an area including analog circuits. The characteristics of the circuits in the analog circuit area **220** are degraded according to the level of noise contained in a handled signal and the level of noise propagated thereto through the semiconductor substrate. Specific examples of the circuits formed in the analog circuit area **220** include a LNA (low noise amplifier) and a mixer for a tuner, and other noise-sensitive analog circuits.

The analog circuit area **230** (a high noise circuit area) is an area where analog circuits that produce high level noise are formed. The noise produced by the circuits in the analog circuit area **230** is at such a level that the characteristics of the circuits in the analog circuit area **220** are caused to degrade beyond their acceptable limits. Specific examples of the circuits formed in the analog circuit area **230** include a PLL circuit for a tuner and other analog circuits.

The analog circuit area **240** (a low noise circuit area) is an area where analog circuits that produce low level noise are formed. The noise produced by the circuits in the analog circuit area **240** is not at such a level that the characteristics of the circuits in the analog circuit area **220** are caused to degrade beyond their acceptable limits. Specific examples of the circuits formed in the analog circuit area **240** include a filter and a VGA for a tuner and other analog circuits.

It should be noted that as in a semiconductor integrated circuit **300** shown in FIG. **4****,** all circuit areas may be areas including digital circuits.

The digital circuits in a digital circuit area **320** (a protected circuit area) are noise-sensitive circuits such as high-speed interfaces, for example. The characteristics of the circuits in the digital circuit area **320** are degraded according to the level of propagated noise.

The digital circuits in a digital circuit area **330** (a high noise circuit area) produce noise at a level corresponding to the operating frequency thereof. The noise produced by the digital circuits in the digital circuit area **330** is at such a level that the characteristics of the circuits in the digital circuit area **320** are caused to degrade beyond their acceptable limits.

The circuits in a digital circuit area **340** (a low noise circuit area) also produce noise at a level corresponding to the operating frequency thereof. Since the operating frequency of the circuits in the digital circuit area **340** is lower than that of the circuits in the digital circuit area **330,** the level of the noise produced by the circuits in the digital circuit area **340** is at such a level that the characteristics of the circuits in the digital circuit area **320** are caused to degrade only within their acceptable limits.

### (Third embodiment)

The number of power sources for supplying power supply voltage to the circuits in each of the protected circuit area, the high noise circuit area, and the low noise circuit area is not limited to the example described above, so long as the power source(s) for supplying power supply voltage to the protected circuit area, the power source(s) for supplying power supply voltage to the low noise circuit area, and the power source(s) for supplying power supply voltage to the high noise circuit area are not connected with each other and are separate from each other.

A semiconductor integrated circuit according to a third embodiment is an example in which the number of power sources for each area such as the protected circuit area is different from that in the first embodiment.

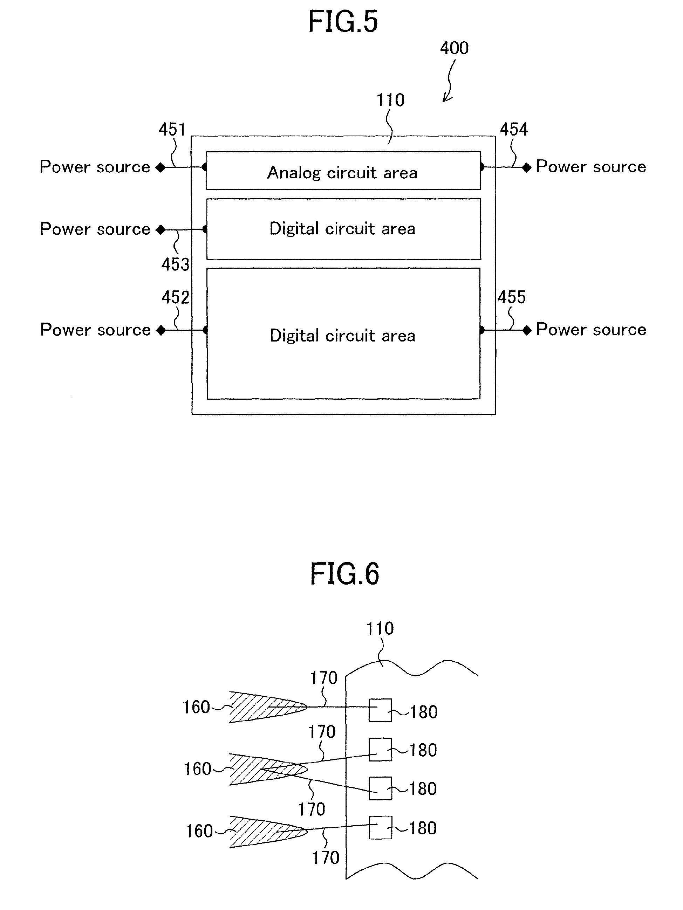

For instance, in the example of a semiconductor integrated circuit **400** shown in FIG. **5****,** five power sources **451** to **455** are provided, and the number of power sources provided is larger than the number of areas, which is three. These power sources are separate from each other, and no single power source supplies power to multiple areas.

It is sufficient if the power sources are separate from each other on the semiconductor substrate. FIG. **6** is a view illustrating connections between the semiconductor substrate **110** and power terminals.

Lead frames **160** (power terminals) are supplied with power supply voltage from outside the semiconductor integrated circuit.

Bonding wires **170** connect the lead frames **160** and bonding pads **180.**

The bonding pads **180** supply the power supply voltage provided through the bonding wires **170** with the circuits in the protected circuit area, high noise circuit area, and low noise circuit area through power wires (not shown).

In this example, as shown in FIG. **6**, one of the lead frames **160** is connected with multiple bonding pads **180.** Therefore, the power sources are not separate from each other at the product terminals, and the same power terminal supplies the power supply voltage to the multiple areas. However, on the semiconductor substrate **110,** the paths for supplying the power to the protected circuit area, to the high noise circuit area, and to the low noise circuit area are separate from each other, which prevents direct propagation of noise through the semiconductor substrate **110.**

### (Fourth embodiment)

The number of protected circuit areas, the number of high noise circuit areas, and the number of low noise circuit areas are not limited to the numbers and to the physical shapes described above, so long as the protected circuit area(s) and the high noise circuit area(s) are physically separated by the low noise circuit area(s) so as to prevent contact between the protected circuit area(s) and the high noise circuit area(s).

A semiconductor integrated circuit according to a fourth embodiment is an example in which the number and shapes of areas such as the protected circuit area are different from those in the first embodiment.

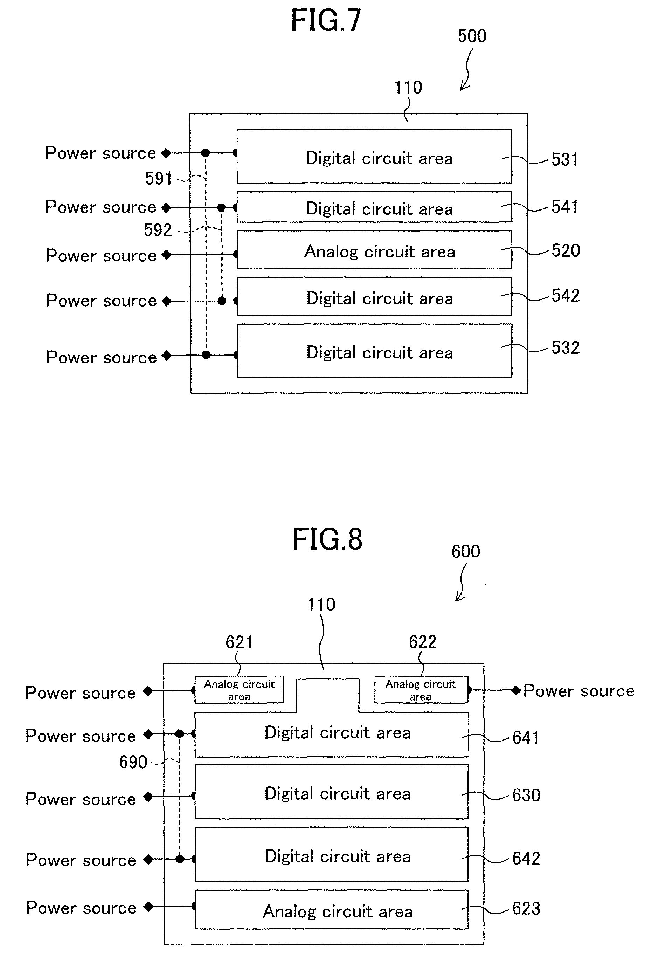

For example, the protected circuit area, the high noise circuit areas, and the low noise circuit areas may be arranged as in a semiconductor integrated circuit **500** shown in FIG. **7****.** As shown in FIG. **7****,** the semiconductor integrated circuit **500** includes a semiconductor substrate **110,** an analog circuit area **520** (a protected circuit area), digital circuit areas **531** and **532** (high noise circuit areas), and digital circuit areas **541** and **542** (low noise circuit areas).

The analog circuit area **520** is an area including analog circuits. Examples of the circuits in the analog circuit area 520 include a tuner, an AD converter, a DA converter, a PLL circuit, a VCO circuit, a filter, an operational amplifier, and other noise-sensitive analog circuits.

The digital circuit areas **531** and **532** and the digital circuit areas **541** and **542** are areas including digital circuits. In this example, the operating frequencies of the circuits in the digital circuit areas **531, 532, 541** and **542** are expressed by f531, f532, f541, and f542, respectively, and it is assumed that the inequality f541≤f542<f531≤f532 holds. In this case, when the levels of noise produced by the circuits in the digital circuit areas **531, 532, 541** and **542** are n531, n532, n541, and n542, respectively, the inequality n541≤n542<n531≤n532 holds. In this exemplary device, when the noise level is n542 or lower, degradation of the characteristics of the circuits in the analog circuit area **520** is within their acceptable limits, but when the noise level is n531 or higher, the characteristics of the circuits in the analog circuit area **520** are degraded beyond their acceptable limits.

The digital circuit area **541** is physically located between the analog circuit area **520** and the digital circuit area **531** so as to prevent contact between the analog circuit area **520** and the digital circuit area **531.** The digital circuit area **542** is also physically located between the analog circuit area **520** and the digital circuit area **532** so as to prevent contact between the analog circuit area **520** and the digital circuit area **532.**

In the semiconductor integrated circuit **500,** power sources for supplying power supply voltage to the above-described respective areas are also separate from each other.

In the semiconductor integrated circuit **500** thus structured, noise produced in the digital circuit areas **531** and **532** does not propagate to the analog circuit area **520** (the protected circuit area) as in the semiconductor integrated circuit **100.** Accordingly, in the semiconductor integrated circuit **500,** it is also possible to prevent degradation of the characteristics of the circuits in the analog circuit area **520.**

In the semiconductor integrated circuit **500,** as shown in FIG. **7****,** the power source for supplying power supply voltage to the digital circuit area **541** and the power source for supplying power supply voltage to the digital circuit area **542** may be connected by a wire **592,** and the power source for supplying power supply voltage to the digital circuit area **531** and the power source for supplying power supply voltage to the digital circuit area **532** may be connected by a wire **591.** Even if the power sources are connected in this way, the power sources for the high noise circuit areas (the digital circuit areas **531** and **532)** and the power sources for the low noise circuit areas (the digital circuit areas **541** and **542)** are separate from each other. Thus, noise occurring in the digital circuit areas **531** and **532** (the high noise circuit areas) is absorbed in the digital circuit areas **541** and **542** and does not propagate to the analog circuit area **520.**

Also, the protected circuit area, the high noise circuit areas, and the low noise circuit areas may be arranged as in a semiconductor integrated circuit **600** shown in FIG. **8****.** As shown in FIG. **8****,** the semiconductor integrated circuit **600** includes a semiconductor substrate **110,** analog circuit areas **621** to **623** (protected circuit areas), a digital circuit area **630** (a high noise circuit area), and digital circuit areas **641** and **642** (low noise circuit areas).

The analog circuit areas **621** to **623** are areas including analog circuits. Examples of the circuits in the analog circuit areas **621** to **623** include a tuner, an AD converter, a DA converter, a PLL circuit, a VCO circuit, a filter, an operational amplifier, and other noise-sensitive analog circuits.

The digital circuit area **630** and the digital circuit areas **641** and **642** are areas including digital circuits. In this example, the operating frequencies of the circuits in the digital circuit areas **630, 641** and **642** are expressed by f630, f641, and f642, respectively, and it is assumed that the inequality f642≤f641<f630 holds. In this case, when the levels of noise produced by the circuits in the digital circuit areas **630, 641** and **642** are expressed by n630, n641, and n642, respectively, the inequality n642≤n641<n630 holds. It is assumed that when the noise level is n641 or lower, degradation of the characteristics of the circuits in the analog circuit areas **621** to **623** is within their acceptable limits, but when the noise level is n630 or higher, the characteristics are degraded beyond their acceptable limits.

As shown in FIG. **8****,** the digital circuit area **641** is physically located between the analog circuit area **621** and the digital circuit area **630** so as to prevent contact between the analog circuit area **621** and the digital circuit area **630.** The digital circuit area **641** is also physically located between the analog circuit area **622** and the digital circuit area **630** so as to prevent contact between the analog circuit area **622** and the digital circuit area **630.** The digital circuit area **642** is physically located between the analog circuit area **623** and the digital circuit area **630** so as to prevent contact between the analog circuit area **623** and the digital circuit area **630.**

In the semiconductor integrated circuit **600,** power sources for supplying power supply voltage to the above-described respective areas are also separate from each other.

In the semiconductor integrated circuit **600** thus structured, noise occurring in the digital circuit area **630** does not propagate to the noise-sensitive analog circuit areas **621** to **623** as in the semiconductor integrated circuit **100.** Accordingly, it is possible to suppress degradation of the characteristics of the circuits in the analog circuit areas **621** to **623** (the protected circuit areas).

In the semiconductor integrated circuit **600,** the power source for supplying power supply voltage to the digital circuit area **641** and the power source for supplying power supply voltage to the digital circuit area **642** may be connected by a wire **690** as shown in FIG. **8****.** Even if the power sources are connected in this way, the power source for the high noise circuit area (the digital circuit area **630)** and the power sources for the low noise circuit areas (the digital circuit areas **641** and **642)** are separate from each other. Thus, noise occurring in the digital circuit area **630** (the high noise circuit area) is absorbed in the digital circuit areas **641** and **642** and does not propagate to the analog circuit areas **621** to **623.**

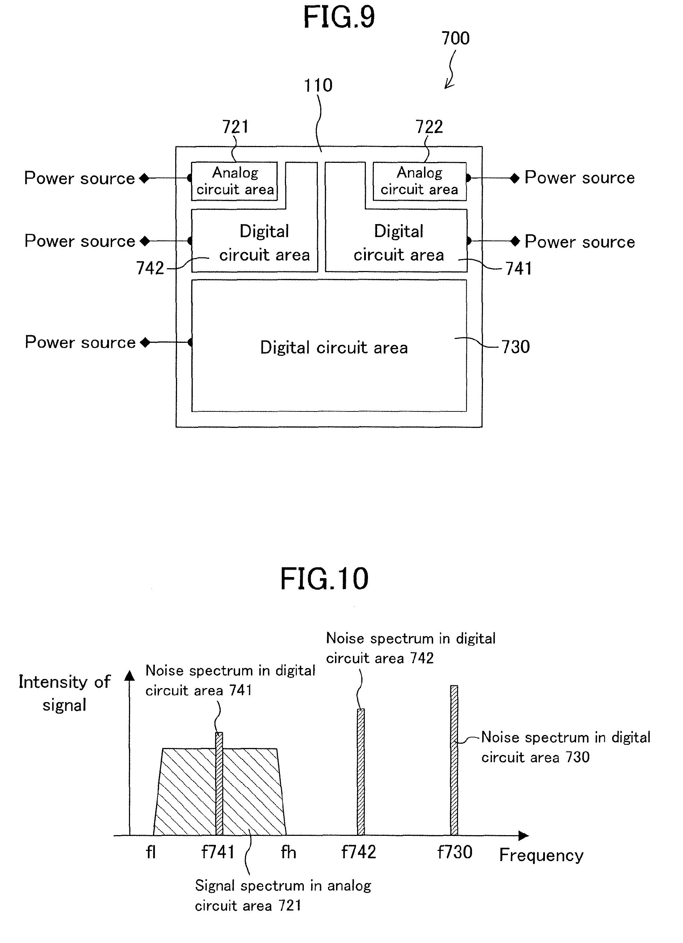

Furthermore, the protected circuit areas, the high noise circuit area, and the low noise circuit areas may be arranged as in a semiconductor integrated circuit **700** shown in FIG. **9****.** As shown in FIG. **9****,** the semiconductor integrated circuit **700** includes a semiconductor substrate **110,** analog circuit areas **721** and **722** (protected circuit areas), a digital circuit area **730** (a high noise circuit area), and digital circuit areas **741** and **742** (low noise circuit areas).

The analog circuit areas **721** and **722** are areas including analog circuits. Examples of the circuits in the analog circuit areas **721** and **722** include a tuner, an AD converter, a DA converter, a PLL circuit, a VCO circuit, a filter, an operational amplifier, and other noise-sensitive analog circuits.

The digital circuit areas **730, 741,** and **742** are areas including digital circuits. In this example, the operating frequencies of the circuits in the digital circuit areas **730, 741** and **742** are expressed by f730, f741, and f742, respectively, and it is assumed that the inequality f741<f742<f730 holds. In this case, when the levels of noise produced by the circuits in the digital circuit areas **730, 741** and **742** are expressed by n730, n741, and n742, respectively, the inequality n741 <n742<n730 holds.

It is also assumed that the lower and upper limit frequencies of the frequency band of signals handled in the analog circuit area **721** are fl and fh, respectively, and that the inequality f1<f741<fh<f742<f730 holds.

As shown in FIG. **9****,** the analog circuit **area** 721 is located so as not to be in contact with the digital circuit area **741.** The digital circuit area **741** is physically located between the analog circuit area **722** and the digital circuit area **730** so as to prevent contact between the analog circuit area **722** and the digital circuit area **730.** The digital circuit area **742** is physically located between the analog circuit area **721** and the digital circuit area **730** so as to prevent contact between the analog circuit area **721** and the digital circuit area **730.**

The reason why the analog circuit area **721** and the digital circuit area **741** are provided so as not to be in contact with each other as described above is because the operating frequency of the circuits in the digital circuit area **741** is within the frequency band of signals handled in the analog circuit area **721,** and noise produced by these circuits thus presumably becomes a direct noise component, although their operating frequency is low and the level of the noise is thus low.

In the semiconductor integrated circuit **700,** power sources for supplying power supply voltage to the above-described respective areas are also separate from each other.

FIG. **10** shows spectral distributions of noise produced in the digital circuit areas **730, 741** and **742** and a spectral distribution of signals handled in the analog circuit area **721.** As can be seen from FIG. **10****,** if the noise produced in the digital circuit areas **730, 741** and **742** is propagated to the analog circuit area **721,** the noise produced in the digital circuit area **741** overlaps the signal band (from fl to fh) handled in the analog circuit area **721** and thus becomes direct noise.

Therefore, in order to prevent the noise produced in the digital circuit area **741** from propagating to the analog circuit area **721,** the analog circuit area **721** and the digital circuit area **741** are located so as not to be in contact with each other.

Accordingly, the high-level noise produced in the digital circuit area **730** does not propagate to the noise-sensitive analog circuit areas **721** and **722,** and the noise produced in the digital circuit area **741** does not propagate to the analog circuit area **721.**

Consequently, in the semiconductor integrated circuit **700,** it is also possible to suppress degradation of the characteristics of the circuits in the protected circuit areas.

It should be noted that as in a semiconductor integrated circuit **800** shown in FIG. **11****,** a guard band area **860** may be additionally provided between the analog circuit area **120** and the digital circuit area **140** in the semiconductor integrated circuit **100.** The guard band area **860** is the same as the guard band area provided in the conventional semiconductor integrated circuit. The addition of the guard band area **860** enables degradation of the characteristics of the circuits in the protected circuit area to be prevented more effectively.

It should be also noted that the circuits formed in the low noise circuit areas are not limited to those analog circuits and digital circuits exemplified above.

Moreover, as the examples of the circuits formed in the high noise circuit areas, the digital circuits that operate at high frequencies have been described. However, the circuits formed in the high noise circuit areas may be any circuits that produce noise causing degradation of the characteristics of the circuits in the protected circuit areas, such as VCOs and other analog circuits that produce high frequencies, and circuits that operate at low frequencies but have high peak current, for example.

Furthermore, the circuits formed in the low noise circuit areas are not limited to digital circuits that operate at low frequencies, but may be any circuits, such as circuits having low peak-current, that produce noise at such a level that the characteristics of the circuits in the protected circuit areas are not caused to degrade.

### INDUSTRIAL APPLICABILITY

The semiconductor integrated circuits according to the present invention produce the effect that degradation of the characteristics of circuits due to noise is prevented without increasing the area of the semiconductor integrated circuit. The inventive semiconductor integrated circuits are thus applicable, for example, to semiconductor integrated circuits in which circuits whose characteristics are degraded due to noise and circuits that produce the noise are both included.

## Claims

1. A semiconductor integrated circuit comprising:
a protected circuit area including circuits whose characteristics are degraded according to the level of noise;
a high noise circuit area including circuits that produce noise at such a level that an amount of degradation caused in the circuits in the protected circuit area due to the noise exceeds an acceptable amount of degradation for the circuits in the protected circuit area;
a low noise circuit area including circuits that produce noise at such a level that an amount of degradation caused in the circuits in the protected circuit area due to the noise is within the acceptable amount of degradation for the circuits in the protected circuit area; and
three or more separate power sources whose paths for supplying power supply voltage are separate from each other,
wherein the low noise circuit area is located between the protected circuit area and the high noise circuit area so as to prevent contact between the protected circuit area and the high noise circuit area; and
the circuits in the protected circuit area, the circuits in the high noise circuit area, and the circuits in the low noise circuit area are supplied with power supply voltage by different power sources of the three or more separate power sources.

2. The semiconductor integrated circuit of Claim 1, wherein the circuits in the high noise circuit area and the circuits in the low noise circuit area produce noise at levels corresponding to the levels of the frequencies of signals handled by these circuits, and
the maximum frequency of the signals handled in the low noise circuit area is lower than the frequencies of the signals handled in the high noise circuit area.

3. The semiconductor integrated circuit of Claim 1, wherein the circuits in the protected circuit area are analog circuits, and
the circuits in the high noise circuit area are digital circuits.

4. The semiconductor integrated circuit of Claim 2, wherein the circuits in the protected circuit area are analog circuits, and
the circuits in the high noise circuit area are digital circuits.
